# EUROPÄISCHE PATENTSCHRIFT

(11) **EP 2 392 202 B1**
(45) Veröffentlichungstag und Bekanntmachung des Hinweises auf die Patenterteilung: **24.12.2014**
(21) Anmeldenummer: 10704086.7
(22) Anmeldetag: 18.01.2010
(51) Int. Cl.: H05K 7/20

(54) **VERFAHREN UND ANORDNUNG ZUM KÜHLEN VON ELEKTRISCHEN UND ELEKTRONISCHEN BAUELEMENTEN UND MODULEINHEITEN IN GERÄTESCHRÄNKEN**
METHOD AND ARRANGEMENT FOR COOLING ELECTRICAL AND ELECTRONIC COMPONENTS AND MODULE UNITS IN ELECTRICAL ENCLOSURES
PROCÉDÉ ET SYSTÈME POUR REFROIDIR DES COMPOSANTS ET DES UNITÉS MODULAIRES ÉLECTRIQUES ET ÉLECTRONIQUES DANS DES ARMOIRES D'INSTRUMENTS

(30) Priorität: 02.02.2009 DE 102009006924
(43) Veröffentlichungstag der Anmeldung: 07.12.2011
(73) Patentinhaber: Knürr GmbH, 94424 Arnstorf (DE)
(72) Erfinder: EBERMANN, Heiko, 01109 Dresden (DE); TREPTE, Wolfgang, 01665 Zehren (DE)
(74) Vertreter: Heim, Hans-Karl
(86) Internationale Anmeldenummer: PCT/EP2010/000251
(87) Internationale Veröffentlichungsnummer: WO 2010/086098

(56) Entgegenhaltungen:
- EP-A2- 0 243 239
- WO-A2-88/02979
- FR-A1- 2 705 523
- US-A1- 2004 231 351

## Beschreibung

Die Erfindung betrifft ein Verfahren zum Kühlen von elektrischen und elektronischen Bauelementen und Moduleinheiten in Geräteschränken und eine Anordnung zum Kühlen von elektrischen und elektronischen Bauelementen und Moduleinheiten.

Die Erfindung ist für alle Kühlsysteme geeignet, bei denen hohe Verlustleistungen von elektrischen und elektronischen Bauelementen und Moduleinheiten, beispielsweise Hochleistungsservern und Mikroprozessoren, mit Hilfe einer im Kreislauf geführten Kühlflüssigkeit, insbesondere Kühlwasser, abgeführt werden.

Bei einer aus EP 1 614 333 B1 bekannten Kühlungsanordnung wird zur Abführung der Verlustwärme der in einem Serverschrank angeordneten Hochleistungsserver Kühlluft in einem geschlossenen Kreislauf geführt und in einem Wärmetauscher mit einem Kühlmedium, bevorzugt mit Kaltwasser aus dem Gebäudenetz, rückgekühlt, so dass die Verlustwärme der Hochleistungsserver nach außen und insbesondere außerhalb des Aufstellungsraums der Schränke abgeführt werden kann.

In der Patentanmeldung DE 10 2007 061 966 A1 wird eine Kühleinheit vorgeschlagen, welche seitlich an einen Geräteschrank oder zwischen zwei Geräteschränken angeordnet werden kann und zur Rückkühlung von Kühlluft aus dem Geräteschrank beziehungsweise aus beiden Geräteschränken und/oder von Umgebungsluft neben Ventilatoreinheiten einen Luft-Wasser-Wärmetauscher aufweist, welcher an das Kaltwassernetz des Gebäudes angeschlossen ist.

Eine wassergekühlte Nachrüstlösung für Serverschränke und dergleichen, welche eine Überhitzung der Hochleistungsserver und anderer Bauteile verhindert, ist aus EP 1 844 637 B1 bekannt. Ein Luft-Wasser-Wärmetauscher wird fest und eine Ventilatortür verschwenkbar an Stelle einer Rücktür mit dem Rack verbunden. Die im offenen System über die Server und dergleichen zugeführte Kühlluft wird zur Entwärmung dem Luft-Wasser-Wärmetauscher und danach der Umgebung zugeführt.

Die bekannten Kühlverfahren und Anordnungen weisen den Nachteil auf, dass die mit einer Kühlflüssigkeit, beispielsweise Kühlwasser aus dem Gebäudenetz, betriebenen Wärmetauscher für eine möglichst effiziente Abführung der Verlustwärme in oder an den Schränken installiert werden, so dass bei Leckagen die Gefahr besteht, dass die in den Schränken untergebrachten elektrischen und elektronischen Bauelemente und Moduleinheiten, beispielsweise durch einen Kurzschluss, beschädigt werden.

Das Gefährdungsrisiko durch eine Leckage steigt bei Kühlungsanordnungen mit Kühlplatten, welche Wärme leitend mit den zu kühlenden Bauelementen beispielsweise insbesondere Kühlwasser, durchströmt werden (DE 10 2005 016 115 A1, DE 10 2005 025 381 A1).

In DE 103 35 197 B4 ist eine Kühlung von elektronischen Bauelementen beschrieben, welche jeweils über eine thermische Schnittstelle mit einem Kühlkörper verbunden sind. Die Kühlkörper werden von Kühlwasser durchströmt, welches im Kreislauf geführt wird.

Die Erfindung ist auch für Kühlungsanordnungen geeignet, bei denen über Steigleitungen und horizontale Verbindungsleitungen eine Kühlflüssigkeit Verteilern zugeführt wird, welche jeweils zwischen zwei übereinander angeordneten Einschüben mit Moduleinheiten, beispielsweise Servern, angeordnet sind. Mit Hilfe von Anschlussleitungen soll die Kühlflüssigkeit in den Kühlkreislauf der einzelnen Rechnereinheiten der Einschübe gelangen und die aufgenommene Verlustleistung in einer Kühlanlage außerhalb des Schrankes abgegeben werden (DE 10 2004 008 461 A1, DE 20 2006 007 275 U1).

Die Vielzahl der erforderlichen Verbindungsleitungen, Kupplungen und auch Verteiler erhöhen das Risiko einer Leckage der Kühlflüssigkeit und dadurch einer Beschädigung oder eines Ausfalls der zu kühlenden elektrischen und elektronischen Bauteile und Moduleinheiten.

Aus DE 10 2006 033 030 A1, CA 1 185 654 A und WO 01/55662 A1 sowie aus FR 2 705 523 A1, US 2004/231351 A1 und WO 88/02979 A2 sind Kühlvorrichtungen für Computer, elektrische und elektronische Geräte und Halbleiteranordnungen bekannt, bei welchen eine Kühlflüssigkeit in einem geschlossenen Kühlkreislauf geführt wird. Die aufgenommene Wärme wird in einem Wärmetauscher abgeführt. Um die mit einer Leckage verbundenen Nachteile, insbesondere eine Zerstörung beziehungsweise Beeinträchtigung der elektrischen und elektronischen Bauteile und Geräte zu vermeiden, wird der Kreislauf der Kühlflüssigkeit mit Hilfe einer Unterdruckeinrichtung mit einem geringeren Arbeitsdruck als der umgebende Luftdruck betrieben. Die Unterdruckeinrichtung muss dabei jeweils derart ausgebildet und angeordnet werden, dass der gesamte Kreislauf mit Unterdruck beaufschlagt werden kann, was mit einem relativ hohen Aufwand beim Betreiben und insbesondere im Falle einer Leckage verbunden ist.

Der Erfindung liegt die **Aufgabe** zugrunde, Verfahren und Anordnung zum Kühlen von elektrischen und elektronischen Bauelementen und Moduleinheiten in Geräteschränken, Racks, Gehäusen und dergleichen so zu gestalten, dass neben einer Verhinderung einer Leckage der Kühlflüssigkeit und des damit einhergehenden Beschädigungs- oder Ausfallrisikos der elektrischen und elektronischen Bauteilen und Moduleinheiten mit einem relativ geringen Aufwand eine besonders effiziente und sichere Kühlung erreicht wird.

Die Erfindung wird in Bezug auf das Verfahren durch die Merkmale des Anspruchs 1 und in Bezug auf die Anordnung durch die Merkmale des Anspruchs 4 gelöst. Zweckmäßige und vorteilhafte Ausgestaltungen sind in den Unteransprüchen und in der Figurenbeschreibung enthalten.

Gemäß der Erfindung wird ein Austreten von Kühlflüssigkeit im Leitungs- und Installationssystem verhindert, indem die Leitungen und Installationen für die Kühlflüssigkeit, insbesondere die Kühleinrichtungen für die elektrischen und elektronischen Bauelemente und Moduleinheiten, beispielsweise Kühlplatten, Kühlkörper usw., beziehungsweise die Kühleinrichtungen für die Kühlluft, das heißt Luft-Flüssigkeits-Wärmetauscher, sowie Verteiler, Zuführ- und Abführleitungen und Verbindungsleitungen, mit Unterdruck, das heißt, mit einem Betriebsdruck kleiner als der atmosphärische Luftdruck, bezogen auf die Temperatur der Kühlflüssigkeit, beaufschlagt werden.

Indem die im Kreislauf geführte Kühlflüssigkeit mit einem Betriebsdruck < 1 bar beaufschlagt wird, drückt der Luftdruck gegen die Kühlflüssigkeit im Falle einer Leckage, weshalb das Austreten von Kühlflüssigkeit vermieden, zumindest aber durch ein Ansteigen des Druckes in der Kühlflüssigkeitsleitung angezeigt wird und mit Hilfe einer entsprechenden Regelung beziehungsweise Steuerung behoben werden kann. Die bekannten Regelungen beziehungsweise Steuerungen sind aufwendig und nicht effektiv, so dass die Kühlung ausfallen und zu Schäden an den elektrischen und elektronischen Bauteilen und Moduleinheiten führen kann.

Erfindungsgemäß wird bei dem Verfahren zum Kühlen von elektrischen und elektronischen Bauelementen und Moduleinheiten in Geräteschränken, bei welchem die Verlustwärme der Bauelemente und Moduleinheiten direkt über Kühleinrichtungen, wie Kühlplatten und dergleichen oder in Schrank-Wärmetauschern mit Hilfe einer im Kreislauf geführten Kühlflüssigkeit abgeführt und von dieser Kühlflüssigkeit in einem Wärmetauscher an ein Kühlmedium übertragen und durch dieses nach außen abgeführt wird, wobei in einer Anlage für die im Kreislauf geführte Kühlflüssigkeit mit Hilfe einer Unterdruckeinrichtung ein Unterdruck erzeugt wird, welcher kleiner als der atmosphärische Luftdruck ist, der Unterdruck beziehungsweise ein Betriebsdruck < 1 bar nur in einem definierten Unterdruckbereich erzeugt.

Bei einem Kühlverfahren mit in einem Rack oder Schrank angeordneten Kühlkörpern oder -vorrichtungen, welche wärmeleitend mit den elektrischen oder elektronischen Bauteilen und Moduleinheiten verbunden und von der Kühlflüssigkeit durchflossen werden, beginnt der Unterdruckbereich erfindungsgemäß an einem Drosselventil oder auch Strangregulierventil in einer Zuführleitung nach dem Wärmetauscher, in welchem die Kühlflüssigkeit gekühlt wird, und reicht über die Kühlvorrichtungen, wie Kühlkörper, Kühlplatten oder Verteiler, an oder in deren unmittelbarer Nähe die elektrischen und elektronischen Bauteile und Moduleinheiten angeordnet sind, bis zu der Unterdruckeinrichtung, welche in einer Rücklaufleitung der mit der Verlustwärme beaufschlagten Kühlflüssigkeit angeordnet ist. Über die Rücklaufleitung wird die erwärmte Kühlflüssigkeit dem Wärmetauscher zugeführt, wobei vor diesem Wärmetauscher eine Umwälzpumpe angeordnet ist.

Bei einem Verfahren mit Abführung der Verlustwärme von elektrischen und elektronischen Bauelementen und Moduleinheiten in einem Geräteschrank mittels Kühlluft, welche in einem dem Schrank zugeordneten Wärmetauscher, nachfolgend Schrank-Wärmetauscher genannt, mit Hilfe einer Kühlflüssigkeit rückgekühlt wird, wobei bei einer Anordnung mehrerer derartiger Schränke die Kühlflüssigkeit in einer Sekundärvorlaufleitung den einzelnen Wärmetauschern der Schränke zugeführt und in einer Sekundärrücklaufleitung einem Wärmetauscher zugeführt und in diesem rückgekühlt wird, wird die Kühlflüssigkeit ebenfalls nur in einem Unterdruckbereich, welcher von einem Drosselventil oder Strangregulierventil in der Sekundärvorlaufleitung, das heißt, nach dem Wärmetauscher, und über die Schrank-Wärmetauscher der einzelnen Geräteschränke und die Sekundärrücklaufleitung bis zu der Unterdruckeinrichtung reicht, mit dem Unterdruck, beispielsweise mit einem Betriebsdruck < 1 bar, beaufschlagt.

Bevorzugt wird ein Unterdruck im Bereich von 20 bis 900 mbar in dem Unterdruckbereich der Installation für die Kühlflüssigkeit bei einer Temperatur der Kühlflüssigkeit von etwa 12 bis 18° C eingestellt.

Es ist vorteilhaft, dass der partielle Siededruck im Unterdruckbereich nicht unterschritten wird, so dass ein Phasenwechsel bei der Kühlflüssigkeit ausgeschlossen ist.

Die Unterdruckeinrichtung kann im Gehäuse des Hochleistungswärmetauschers angeordnet werden. Es ist alternativ auch möglich, jeweils eine Unterdruckeinrichtung im Bereich der einzelnen Schrank-Wärmetauscher der Geräteschränke vorzusehen.

Die erfindungsgemäße Kühlungsanordnung mit einer Installation für eine im Kreislauf geführte Kühlflüssigkeit, welche Kühlvorrichtungen beziehungsweise Schrank-Wärmetauscher, einen Wärmetauscher zur Abkühlung der Kühlflüssigkeit mit Hilfe eines nach außen abführbaren Kältemittels, eine Zuführleitung und Rücklaufleitung beziehungsweise eine Sekundärvorlaufleitung und Sekundärrücklaufleitung für die Kühlflüssigkeit aufweist, und mit einer Unterdruckeinrichtung, welche in der Installation für die Kühlflüssigkeit zur Erzeugung eines Unterdruckes, welcher kleiner als der atmosphärische Luftdruck ist, angeordnet ist, weist in der Installation für die Kühlflüssigkeit einen Unterdruckbereich auf, welcher von einem Drosselventil in der Zuführleitung über die Kühlvorrichtungen bis zu der Unterdruckeinrichtung in der Rücklaufleitung für die Kühlflüssigkeit im Falle der direkten Kühlung mittels Kühlvorrichtungen und im Falle einer Schrankanordnung mit mehreren Geräteschränken und Schrank-Wärmetauschern von einem Drosselventil in der Sekundärvorlaufleitung über die Schrank-Wärmetauscher bis zu der Unterdruckeinrichtung in der Sekundärrücklaufleitung reicht.

Erfindungsgemäß ist die Unterdruckeinrichtung neben dem Drossel- beziehungsweise Strangregulierventil, welches den Beginn des Unterdruckbereichs für die Kühlflüssigkeit realisiert, mit einem Luftabscheider oder Luftsammler versehen, welcher einen Druckschalter und eine Vakuumpumpe aufweist. Der Luftabscheider ist als Ausdehnungsgefäß und Wasserreserve ausgebildet und luftseitig mit der Vakuumpumpe verbunden.

Die Vakuumpumpe hat die Aufgabe, den Druck in der Kühlflüssigkeitsanlage außerhalb des Wärmetauschers, welcher mit Hilfe eines Kältemittels der Abkühlung der Kühlflüssigkeit dient, bei einem vorgegebenen Wert unterhalb des atmosphärischen Druckes zu halten. Wenn eine Undichtigkeit in den Leitungen oder auch Kupplungen auftritt, saugt die Vakuumpumpe die an dieser Stelle eintretende Luft ab, welche nach der Vakuumpumpe wieder nach außen abgeführt wird.

Anstelle einer Vakuumpumpe kann der Unterdruck auch mit einer Venturidüse erzeugt werden, welche mit Druckluft beaufschlagt wird.

Erfindungsgemäß ist der Vakuumpumpe ein Magnetventil vorgeschaltet, und dieses Magnetventil ist wie die Vakuumpumpe und das Drossel- beziehungsweise Strangregulierventil in der Vorlaufleitung der Kühlflüssigkeit durch einen Druckschalter steuerbar.

Erfindungsgemäß ist der Druckschalter in den Luftabscheider eingebaut und als ein zweistufiger Differenzdruckschalter zur Steuerung des der Vakuumpumpe vorgeschalteten Magnetventils, der Vakuumpumpe und eines dem Drossel- beziehungsweise Strangregulierventil zur Erzeugung des Unterdruckes nachgeschalteten Magnetventils in der Vorlaufleitung sowie entsprechender Regelstrecken ausgebildet.

Der Druckschalter schaltet bei einem Druckanstieg über einen Sollwert die Vakuumpumpe zum Absaugen eines Luft/Wasser-Gemisches beziehungsweise von in der Leitung befindlicher Luft ein, und gleichzeitig wird das Magnetventil vor der Vakuumpumpe geöffnet. Bei einem Druckanstieg über einen Alarmwert schließt das dem Drossel- beziehungsweise Strangregulierventil nachgeschaltete Magnetventil in der Vorlaufleitung. Damit wird vorteilhaft verhindert, dass die zur Umwälzung der Kühlflüssigkeit, insbesondere Kühlwasser, vor dem Wärmetauscher angeordnete Pumpe Kühlflüssigkeit beziehungsweise Wasser aus einem möglichen Leck fördert.

Der Wärmetauscher zur Abkühlung der im Kreislauf geführten Kühlflüssigkeit kann ein Wasser/Wasser- oder ein Wasser/Kältemittel-Wärmetauscher sein, so dass das Kältemittel beziehungsweise das Kaltwasser aus dem Gebäudenetz die von der Kühlflüssigkeit beziehungsweise dem Kühlwasser aufgenommene Verlustwärme nach außen und damit außerhalb eines Aufnahmeraums für eine Mehrzahl von Racks beziehungsweise Geräte- und/oder Serverschränken abgeführt wird.

Die Vorteile des erfindungsgemäßen Verfahrens und der erfindungsgemäßen Kühlungsanordnung mit einem definierten Unterdruckbereich für die im Kreislauf geführte Kühlflüssigkeit bestehen in der sicheren Vermeidung von Beschädigungen und Ausfällen der zu kühlenden elektrischen und elektronischen Bauelemente und Moduleinheiten in einem Geräteschrank infolge einer Leckage und Austretens der Kühlflüssigkeit. Es ist besonders vorteilhaft, dass die Kühlungsanordnung mit der erfindungsgemäßen Unterdruckeinrichtung für alle wassergekühlten Kühlungsanordnungen geeignet ist und besonders vorteilhaft bei Kühlungsanordnungen mit einer an die Bauelemente und Moduleinheiten herangeführten Flüssigkeits- beziehungsweise Wasserkühlung, eingesetzt werden kann. Gleichzeitig ist die Unterdruckeinrichtung relativ einfach und montagefreundlich ausgebildet und relativ kostengünstig zu realisieren.

Die Erfindung wird nachstehend anhand einer Zeichnung weiter erläutert, in dieser zeigen in einer stark schematisierten Darstellung
- Fig. 1: eine Kühlungsanordnung für einen Geräteschrank mit Flüssigkeitskühlung der elektrischen und elektronischen Bauelemente und Moduleinheiten; und
- Fig. 2: eine Kühlungsanordnung für in Geräteschränken aufgenommene und mittels Kühlluft und Luft-Fluid-Wärmetauschern gekühlte elektrische und elektronische Bauelementen und Moduleinheiten sowie einem Wärmetauscher für die Kühlflüssigkeit der einzelnen Geräteschränke.

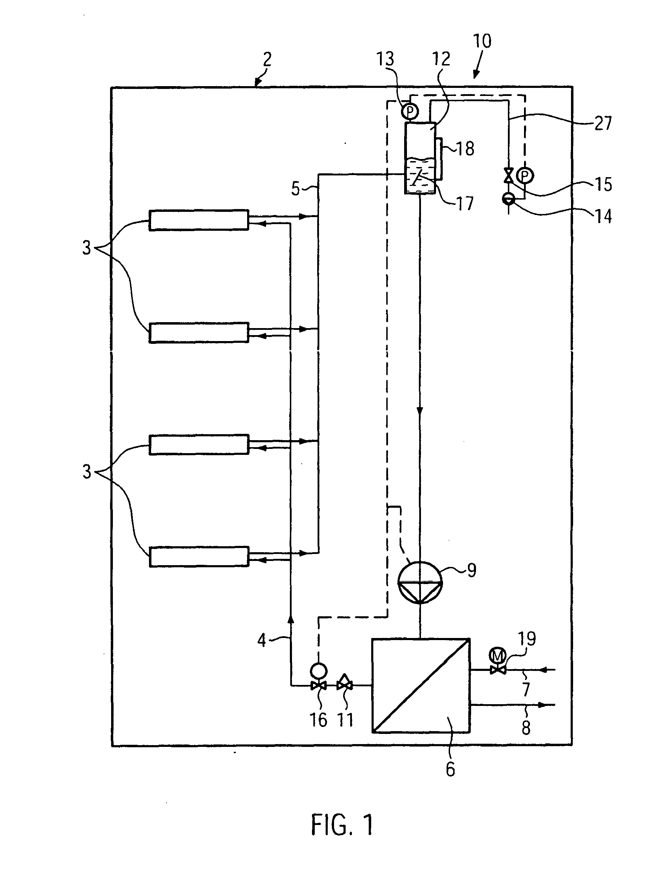

Fig. 1 zeigt eine Kühlungsanordnung für einen Geräteschrank 2, in welchem elektrische und elektronische Bauelemente und Moduleinheiten, beispielsweise Hochleistungsserver, angeordnet sind und mit Kühlwasser als Kühlflüssigkeit gekühlt werden. Die Kühlflüssigkeit wird dabei bis an die Bauteile und Moduleinheiten herangeführt, wobei die im Stand der Technik gewürdigten Lösungen, das heißt, das Anbringen der Bauteile und Moduleinheiten auf Kühlvorrichtungen, wie Kühlblöcken, Kühlkörpern, Kühlplatten und dergleichen, beziehungsweise das Heranführen des Kühlwassers bis an oder auf Boards, zur Anwendung kommen kann. Zur Vereinfachung sind in Fig. 1 die elektrischen und elektronischen Bauteile und Moduleinheiten und Kühlvorrichtungen jeweils als eine Einheit dargestellt und mit dem Bezugszeichen 3 bezeichnet.

Die Kühlflüssigkeit, welche mit einer Temperatur im Bereich von ca. 10°C bis 40°C aus einem Wärmetauscher 6 austritt und über eine Zuführleitung 4 über Abzweigungen zu den Kühlvorrichtungen 3 gelangt, wird nach der Aufnahme der Verlustwärme der elektrischen und elektronischen Bauelemente und Moduleinheiten, über eine Rücklaufleitung 5 und eine Umwälzpumpe 9, welche insbesondere eine Hocheffizienzpumpe ist, einem Wärmetauscher 6 zur Rückkühlung zugeführt. In der Regel herrscht in der Kühlflüssigkeitsinstallation ein Absolutdruck von 0,02 bar bis 0,9 bar, und die mit der Verlustwärme beaufschlagte Kühlflüssigkeit, bei der es sich im vorliegenden Ausführungsbeispiel um Kühlwasser handelt, hat eine Temperatur von ca. 18°C bis ca. 50°C.

Der Wärmetauscher 6 ist ein Wasser/Wasser-Wärmetauscher und über eine Vorlaufleitung 7 mit einem Regelventil 19 zum Regulieren der Temperatur der den Kühlvorrichtungen 3 zugeführten Kühlflüssigkeit sowie einer Rücklaufleitung 8 an das Kaltwassernetz des Gebäudes angeschlossen. Grundsätzlich kann anstelle des Kaltwassers aus dem Gebäudenetz auch ein anderes Kältemittel auf der Primärseite des Wärmetauschers 6 eingesetzt werden.

Um ein Austreten von Kühlflüssigkeit in den Geräteschrank 2 und eine damit verbundene Beschädigung der Bauteile und Moduleinheiten zu verhindern, ist eine Unterdruckeinrichtung 10 vorgesehen, welche derart angeordnet und ausgebildet ist, dass nur in einem definierten Unterdruckbereich und wenigstens im Bereich der Kühlvorrichtungen 3 für die elektrischen und elektronischen Bauelemente und Moduleinheiten ein Betriebsdruck herrscht, welcher kleiner als der atmosphärische Luftdruck und damit kleiner 1 bar ist. Beispielsweise kann in dem Unterdruckbereich ein Betriebsdruck im Bereich von 20 bis 900 mbar eingestellt werden, wobei der partielle Siededruck der Kühlflüssigkeit nicht unterschritten wird, um einen Phasenwechsel der Kühlflüssigkeit auszuschließen.

Die Unterdruckeinrichtung 10 weist eine Vakuumpumpe 14 auf, welche luftseitig an einen Luftabscheider 12 angeschlossen ist. Diese Vakuumpumpe 14 hält den Betriebsdruck in der Anlage für die Kühlflüssigkeit unter den atmosphärischen Druck, und bei Auftreten einer Undichtigkeit, beispielsweise in der Zuführleitung 4, im Bereich der Kühlvorrichtungen 3 und/oder in der Rücklaufleitung bis zum Luftabscheider 12 wird die aufgrund des Unterdrucks eintretende Luft nach außen abgeführt.

Der Luftabscheider 12, welcher auch als Luftsammler bezeichnet werden kann, dient grundsätzlich als Ausdehnungsgefäß und Wasserreserve und nimmt auch Kühlflüssigkeit auf, welche durch die Vakuumpumpe 14 bei einer eventuellen Leckage angesaugt wird. Außerdem dient der Luftabscheider 12 zur Luftabscheidung, wenn Luft durch eine Undichtigkeit in das System eingetreten ist. Ein im Luftabscheider 12 angeordnetes Lochblech 17 dient der Luftabscheidung, und diese Luft wird durch die Vakuumpumpe 14 und eine Vakuumleitung 27 zwischen dem Luftabscheider 12 und der Vakuumpumpe 14 abgesaugt.

Der Luftabscheider 12 ist mit einem Druckschalter 13 versehen, welcher als ein zweistufiger Differenzdruckschalter ausgebildet ist. Beim Ansteigen des Druckes wird die Vakuumpumpe 14 eingeschaltet und ein der Vakuumpumpe 14 vorgeschaltetes Magnetventil 15 geöffnet. Das vakuumseitige Magnetventil 15 verhindert ein Rückströmen von Luft, wenn die Vakuumpumpe 14 abgeschaltet ist und wird zudem durch den Druckschalter 13 bei einem Ansteigen des Druckes über einen Alarmwert geschlossen.

Der Druckschalter 13 steuert neben dem vakuumseitigen Magnetventil 15 und der Vakuumpumpe 14 ein Magnetventil 16 in der Zuführleitung 4, welches dem Wärmetauscher 6 nachgeschaltet ist und die Zuführleitung 4 für die Kühlflüssigkeit automatisch schließt, wenn der Betriebsdruck ansteigt. Damit wird verhindert, dass die Pumpe 9 Kühlflüssigkeit beziehungsweise Kühlwasser aus einem möglichen Leck fördert.

Das Drosselventil 11 beziehungsweise Strangregulierventil dient der Erzeugung des Unterdrucks nach dem Wärmetauscher 6 und definiert den Beginn des Unterdruckbereiches. Der eingestellte Unterdruck beziehungsweise Differenzdruck wird dabei automatisch geregelt.

Der Überwachung der Unterdruckeinrichtung dient auch ein Schauglas 18 am Luftabscheider 12.

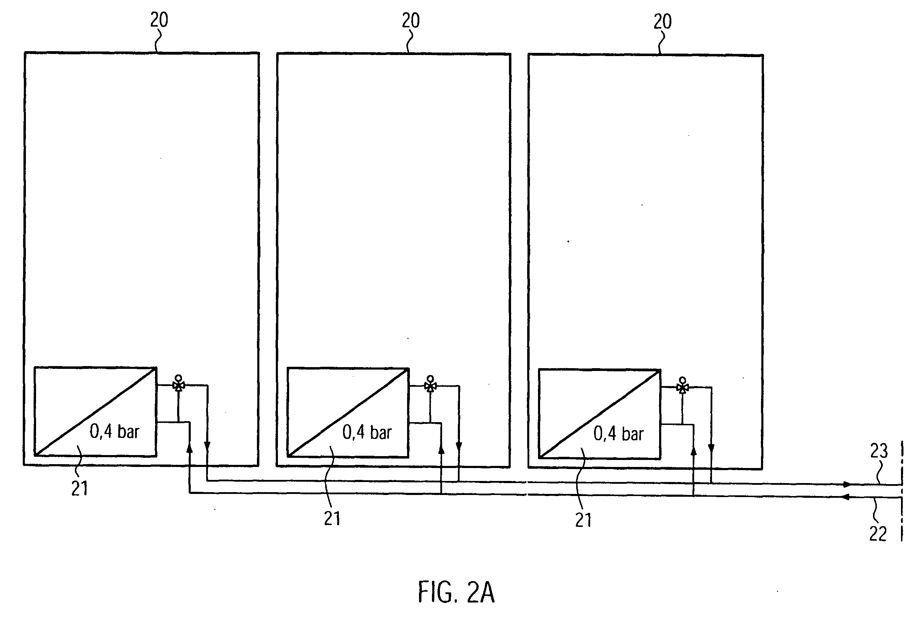

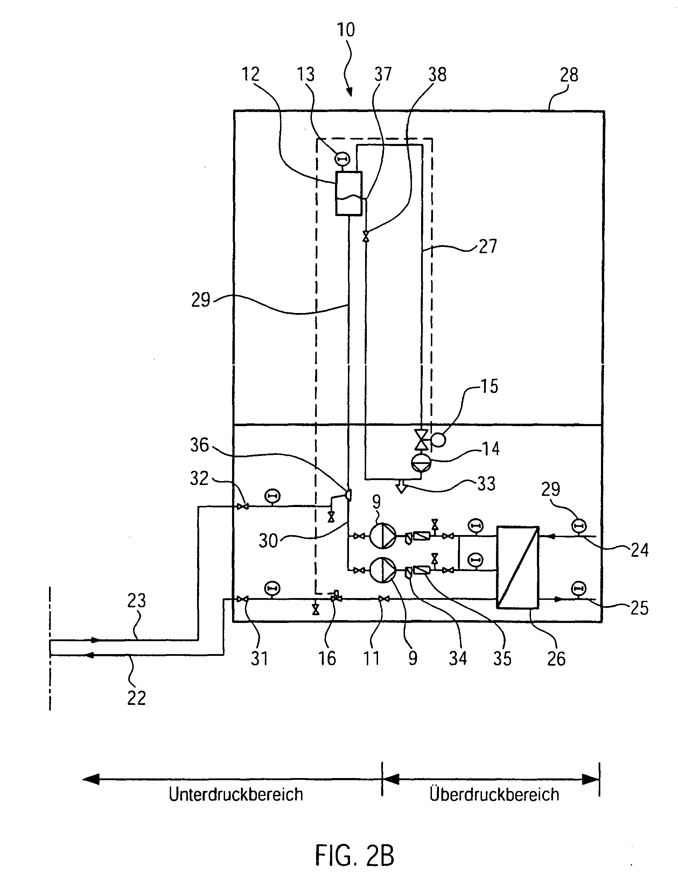

In Fig. 2 ist stark schematisiert eine Kühlungsanordnung für mehrere Geräteschränke 20 gezeigt, in welchen jeweils ein Schrank-Wärmetauscher 21 zur Rückkühlung von Kühlluft angeordnet ist, welche in diesem Ausführungsbeispiel in einem geschlossenen Kreislauf innerhalb jedes Geräteschrankes 20 geführt und die Verlustwärme von elektrischen und elektronischen Bauteilen und Moduleinheiten (nicht dargestellt) an die Kühlflüssigkeit des Wärmetauschers 21 abgibt.

Bei den Wärmetauschern 21 der einzelnen Geräteschränke 20 handelt es sich um Luft-Wasser-Wärmetauscher, und diese Wärmetauscher 21 sind im vorliegenden Ausführungsbeispiel bodenseitig in den einzelnen Geräteschränke 20 angeordnet. Grundsätzlich kann ein derartiger Wärmetauscher 21 auch als ein Einschub oder in einem oberen Bereich innerhalb der einzelnen Geräteschränke 20 angeordnet sein oder auch seitlich und im Bereich einer oberen Abdeckung außerhalb eines Geräteschrankes oder als Front- oder Rücktür vorgesehen sein.

Bei der Kühlungsanordnung der Fig. 2 sind drei Geräteschränke 20 mit zugehörigen Wärmetauschern 21 gezeigt, welche in Bezug auf die zugeführte Kühlflüssigkeit in Reihe geschaltet sind.

Als Kühlflüssigkeit wird Kühlwasser über eine Sekundärvorlaufleitung 22 den Geräteschränken 20 beziehungsweise den Wärmetauschern 21 zugeleitet. Die mit der Verlustwärme beaufschlagte Kühlflüssigkeit gelangt aus den Wärmetauschern 21 in eine Sekundärrücklaufleitung 23 und mit Hilfe von Umwälzpumpen 9, welche in einer redundanten Anordnung vorgesehen sind, in einen Wärmetauscher 26, in welchem die Energie von einer Primärseite, hier dem Wassernetz des Gebäudes, auf die Sekundärseite, das heißt, die Geräteschränke 20 beziehungsweise Rack übertragen wird.

Bei dem Wärmetauscher 26 handelt es sich um einen Hochleistungswärmetauscher, welchem als Kältemittel Kaltwasser aus dem Gebäudenetz über eine Primärvorlaufleitung 24 zugeführt wird. Die Abführung des mit der Verlustwärme aus den Geräteschränken 20 beladenen Kältemittels erfolgt über eine Primärrücklaufleitung 25. Die Temperatur des Kältemittels in der Vorlaufleitung kann etwa 22°C betragen, während die Temperatur in der Rücklaufleitung im Bereich von 28°C beziehungsweise 29°C liegen kann.

In dem vorliegenden Ausführungsbeispiel ist der Hochleistungs-Wasser-Wasser-Wärmetauscher 26 mit entsprechenden Bauteilen, Ventilen, Steuerelementen und dergleichen und mit der erfindungsgemäßen Unterdruckeinrichtung 10 in einer Einrichtung 28 angeordnet, welche eine Schnittstelle zwischen dem Primär-Kaltwassernetz des Gebäudes und dem Sekundär-Kaltwasserkreislauf für die in einem Rechner- oder Serverraum angeordneten Schränke bildet und beispielsweise als "Knürr CoolTrans" bekannt ist und besondere Vorteile in Bezug auf die Regelung des sekundären Kühlwasserkreislaufes aufweist.

Die Unterdruckeinrichtung 10 weist wiederum eine Vakuumpumpe 14 auf, welche den Betriebsdruck in einem Unterdruckbereich, welcher an einem Drosselventil 11 in der Sekundärvorlaufleitung 22 und nach dem Hochleistungswärmetauscher 26 beginnt und bis zur Unterdruckeinrichtung 10 beziehungsweise der Vakuumpumpe 14 reicht, aufrecht erhält, und unter dem atmosphärischen Druck, beispielsweise bei einem Druck von 900 mbar, hält. Der Betriebsdruck kann auch 400, 500, 600, 700, 800 +/- 50 mbar betragen.

Der Vakuumpumpe 14 ist ein Magnetventil 15 vorgeschaltet, welches von einem Druckschalter 13 im Luftabscheider 12 gesteuert wird. Dieser Druckschalter 13 arbeitet wie bei der Kühlungsanordnung nach Fig. 1 und steuert das vakuumseitige Magnetventil 15, die Vakuumpumpe 14 sowie ein wasserseitiges Magnetventil 16, welches nach dem Drosselventil 11 angeordnet ist. Eine Vakuumleitung 27 reicht von der Luftseite des Luftabscheiders 12 bis zur Vakuumpumpe 14.

In der Sekundärvorlaufleitung 22, und dem wasserseitigen Magnetventil 16 nachgeschaltet, ist ein Absperrventil 31 im Bereich der Schnittstelleneinrichtung 28 angeordnet. In gleicher Weise ist in der Sekundärrücklaufleitung 23 ein Absperrventil 32 vorgesehen. Zwischen der Sekundärrücklaufleitung 23 und einer Steigleitung 29 zum Luftabscheider 12 ist ein Luftvorabscheider 36 angeordnet, welcher der Verlangsamung der Strömungsgeschwindigkeit zwischen der Steigleitung 29 und einer zu den Umwälzpumpen 9 führenden Rohrleitung 30 dient. Zwischen den Umwälzpumpen 9 und der Zuführleitung für die im Hochleistungswärmetauscher 26 rückzukühlende Kühlflüssigkeit sind jeweils Filter 34 zur Ausscheidung eventueller Verschmutzungen aus dem sekundären Kühlflüssigkeitskreislauf sowie Rückschlagklappen 35 zum Verhindern von Rückströmungen angeordnet.

Im Bereich des Luftabscheiders 12 ist außerdem eine Leitung 37 zum Befüllen der Anlage mit Kühlflüssigkeit, vorliegend mit Kühlwasser, angeordnet. Die maximale Füllhöhe ist festgelegt, da bei einer weiteren Befüllung das Wasser in die Entwässerung abgeführt wird. Ein Ventil 38 ist während des Normalbetriebes geschlossen, während es bei Befüllung geöffnet ist, um den maximalen Füllstand vorzugeben. Endseitig ist die Leitung 37 mit einem Trichter 33 zur Zuführung eines Wasser-Luftgemisches in eine Wasserleitung (nicht dargestellt) gezeigt.

## Patentansprüche

1. Verfahren zum Kühlen von elektrischen und elektronischen Bauelementen und Moduleinheiten in Geräteschränken (2, 20), insbesondere Serverschränken, bei welchem die Verlustwärme der elektrischen und elektronischen Bauelemente und Moduleinheiten in Kühlvorrichtungen (3) an oder in unmittelbarer Nähe der elektrischen und elektronischen Bauelemente und Moduleinheiten oder in Schrank-Wärmetauschern (21), welche einem Geräteschrank (20) zur Rückkühlung von zur Abführung von Verlustwärme der elektrischen und elektronischen Bauelemente und Moduleinheiten verwendeter Kühlluft zugeordnet sind, mit Hilfe einer im Kreislauf geführten Kühlflüssigkeit abgeführt und von dieser Kühlflüssigkeit in einem Wärmetauscher (6, 26) an ein Kältemittel übertragen und durch dieses nach außen abgeführt wird, wobei die Kühlflüssigkeit mit Hilfe einer Umwälzpumpe (9), welche vor dem Wärmetauscher (6, 26) angeordnet ist, im Kreislauf geführt wird und mit Hilfe einer Unterdruckeinrichtung in der Anlage für die Kühlflüssigkeit ein Unterdruck erzeugt wird, welcher kleiner als der atmosphärische Luftdruck ist, wobei der Unterdruck nur in einem Unterdruckbereich erzeugt wird, welcher an einem Drosselventil (11) in einer Zuführleitung (4) von dem Wärmetauscher (6) zu den Kühlvorrichtungen (3) beziehungsweise in einer Sekundärvorlaufleitung (22) von dem Wärmetauscher (26) zu den Schrank-Wärmetauschern (21) beginnt und über die Kühlvorrichtungen (3) beziehungsweise Schrank-Wärmetauscher (21) bis zu der Unterdruckeinrichtung (10) in einer entsprechenden Rücklaufleitung (5) beziehungsweise Sekundärrücklaufleitung (23) für die Kühlflüssigkeit reicht,
**dadurch gekennzeichnet,**
**dass** der Unterdruck in dem Unterdruckbereich mit Hilfe einer Vakuumpumpe (14) eingestellt wird, welche über eine Vakuumleitung (27) mit einem Luftabscheider (12) verbunden ist und den Betriebsdruck in der Kühlflüssigkeitsanlage im Unterdruckbereich unterhalb des atmosphärischen Drucks hält,
**dass** ein der Vakuumpumpe (14) auf der Vakuumseite vorgeschaltetes Magnetventil (15) von einem am Luftabscheider (12) angeordneten Druckschalter (13) gesteuert wird, welcher als zweistufiger Differenzdrückschalter ausgebildet ist, und dass bei einem Druckanstieg die Vakuumpumpe (14) eingeschaltet und das ihr vorgeschaltete Magnetventil (15) geöffnet wird und bei einem weiteren Ansteigen des Druckes über einen Alarmwert ein Magnetventil (16) in der Zuführleitung (4) beziehungsweise Sekundärvorlaufleitung (22) für die Kühlflüssigkeit geschlossen wird.

2. Verfahren nach Anspruch 1,
**dadurch gekennzeichnet,**
**dass** in dem Unterdruckbereich ein Betriebsdruck zwischen 20 und 900 mbar, bei einer Temperatur der Kühlflüssigkeit von etwa 12 bis 18°C, erzeugt wird.

3. Verfahren nach Anspruch 1 oder 2,
**dadurch gekennzeichnet,**
**dass** als Kühlflüssigkeit Wasser eingesetzt wird.

4. Kühlungsanordnung für elektrische und elektronische Bauelemente und Moduleinheiten, insbesondere Hochleistungsserver, welche in Geräteschränken (2, 20) und dergleichen aufgenommen sind,
mit einer Installation für eine im Kreislauf geführte Kühlflüssigkeit, welche Kühlvorrichtungen (3) beziehungsweise Schrank-Wärmetauscher (21), einen Wärmetauscher (6, 26) zur Abkühlung der Kühlflüssigkeit mit Hilfe eines nach außen abführbaren Kältemittels, wenigstens eine Umwälzpumpe (9) zur Umwälzung der Kühlflüssigkeit und Realisierung des Kühlflüssigkeitskreislaufes, welche vor dem Wärmetauscher (6, 26) angeordnet ist, eine Zuführleitung (4) und Rücklaufleitung (5) beziehungsweise eine Sekundärvorlaufleitung (22) und Sekundärrücklaufleitung (23) für die Kühlflüssigkeit aufweist, wobei die Kühlvorrichtungen (3) an oder in unmittelbarer Nähe der elektrischen und elektronischen Bauelemente und Moduleinheiten angeordnet und die Schrank-Wärmetauscher (21) jeweils einem Geräteschrank (20) zur Rückkühlung von zur Abführung der Verlustwärme der elektrischen und elektronischen Bauelemente und Moduleinheiten verwendeter Kühlluft zugeordnet sind, und die Zuführleitung (4) von dem Wärmetauscher (6) zu den Kühlvorrichtungen (3) und die Rücklaufleitung (5) von den Kühlvorrichtungen (3) zu dem Wärmetauscher (6) bzw. die Sekundärvorlaufleitung (22) von dem Wärmetauscher (26) zu den Schrank-Wärmetauschern (21) und die Sekundärrücklaufleitung (23) von den Schrank-Wärmetauschern (21) zu dem Wärmetauscher (26) reicht,
mit einer Unterdruckeinrichtung (10), welche in der Installation (3, 4, 5, 9; 21, 22, 23) für die Kühlflüssigkeit zur Erzeugung eines Unterdrucks, welcher kleiner als der atmosphärische Luftdruck ist, angeordnet ist, wobei in der Installation (3, 4, 5, 9; 21, 22, 23) für die Kühlflüssigkeit ein Unterdruckbereich ausgebildet ist, welcher von einem Drosselventil (11) in der Zuführleitung (4) über die Kühlvorrichtungen (3) bis zu der Unterdruckeinrichtung (10) in der Rücklaufleitung (5) beziehungsweise von der Sekundärvorlaufleitung (22) über die Schrank-Wärmetauscher (21) bis zu der Unterdruckeinrichtung (10) in der Sekundärrücklaufleitung (23) reicht,
**dadurch gekennzeichnet,**
**dass** die Unterdruckeinrichtung (10) neben dem Drosselventil (11) zur Einstellung des Unterdrucks in dem Unterdruckbereich einen Luftabscheider (12) und eine Vakuumpumpe (14) aufweist, welche über eine Vakuumleitung (27) mit dem Luftabscheider (12) verbunden ist und den Betriebsdruck in der Kühlflüssigkeitsanlage im Unterdruckbereich unterhalb des atmosphärischen Drucks hält,
**dass** der Vakuumpumpe (14) ein Magnetventil (15) auf ihrer Vakuumsseite vorgeschaltet ist, und
**dass** am Luftabscheider (12) ein Druckschalter (13) zur Steuerung des Magnetventils (15), der Vakuumpumpe (14) und eines Magnetventils (16) in der Zuführleitung (4) beziehungsweise Sekundärvorlaufleitung (22) angeordnet ist, welcher als zweistufiger Differenzdruckschalter ausgebildet ist und bei einem Druckanstieg die Vakuumpumpe (14) einschaltet und das ihr vorgeschaltete Magnetventil (15) öffnet und bei einem weiteren Ansteigen des Druckes über einen Alarmwert das Magnetventil (16) in der Zuführleitung (4) beziehungsweise Sekundärvorlaufleitung (22) für die Kühlflüssigkeit schließt.

5. Kühlungsanordnung nach Anspruch 4,
**dadurch gekennzeichnet,**
**dass** als Kühlflüssigkeit Kühlwasser und als Kältemittel Kaltwasser aus dem Gebäudewassernetz oder ein Kältemittel eingesetzt ist und dass das Kaltwasser oder Kältemittel über eine Zuführlaufleitung (7) beziehungsweise Primär-Vorlaufleitung (24) dem Wärmetauscher (6, 26) zugeführt und über eine Rücklaufleitung (8) beziehungsweise Primär-Rücklaufleitung (25) abgeführt wird.

6. Kühlungsanordnung nach Anspruch 4 oder 5,
**dadurch gekennzeichnet,**
**dass** bei einem Kühlflüssigkeitskreislauf zur Versorgung der Schrank-Wärmetauscher (21) in Geräteschränken (20) einer Schrankanordnung die Unterdruckeinrichtung (10), der Wärmetauscher (26) und redundante Umwälzpumpen (9) in einer Einrichtung (28) angeordnet sind, welche eine Schnittstelle zwischen dem Kaltwassernetz des Gebäudes als Primärseite und der Kühlflüssigkeitsversorgung der Schränke beziehungsweise Racks als Sekundärseite bildet.

7. Kühlungsanordnung nach Anspruch 4,
**dadurch gekennzeichnet,**
**dass** bei einer Schrankanordnung mit mehreren Geräteschränken (20) und jeweils einem Luft-Flüssigkeits-Wärmetauscher als Schrank-Wärmetauscher (21) in jedem Schrank (20) eine Unterdruckeinrichtung (10) angeordnet beziehungsweise einem Schrank (20) zugeordnet ist.

## Claims

1. Method for cooling electrical and electronic components and module units in device cabinets (2, 20), in particular server cabinets, wherein the heat loss of the electrical and electronic components and module units is removed in cooling devices (3) on or in direct proximity to the electrical and electronic components and module units or in cabinet heat exchangers (21), which are assigned to a device cabinet (20) for re-cooling of cooling air used to remove heat loss of the electrical and electronic components and module units, with the aid of a cooling liquid circulating in the circuit and is transferred from this cooling liquid in a heat exchanger (6, 26) to a refrigerant and outwardly discharged by this refrigerant, wherein the cooling liquid is circulated in the circuit with the aid of a circulating pump (9) which is arranged upstream of the heat exchanger (6, 26), and a low pressure is generated with the aid of a low pressure device in the installation for the cooling liquid, this low pressure being lower than the atmospheric air pressure, wherein the low pressure is only generated in a low pressure range which begins at a throttle valve (11) in a feed line (4) from the heat exchanger (6) to the cooling devices (3) or respectively in a secondary feed line (22) from the heat exchanger (26) to the cabinet heat exchangers (21) and extends via the cooling devices (3) or respectively cabinet heat exchangers (21) as far as the low pressure device (10) in a corresponding return line (5) or respectively secondary return line (23) for the cooling liquid,
**characterised in that**
the low pressure is adjusted in the low pressure range with the aid of a low pressure pump (14) which is connected via a low pressure line (27) to an air separator (12) and keeps the operating pressure in the cooling liquid installation in the low pressure range below the atmospheric pressure,
a solenoid (15) arranged upstream of the low pressure pump (14) on the low pressure side is controlled by a pressure switch (13) arranged on the air separator (12), which is formed as a two-stage differential pressure switch, and that, in the event of a pressure increase, the low pressure pump (14) is switched on and the solenoid (15) arranged upstream thereof is opened and, in the event of a further increase in the pressure above an alarm value, a solenoid (16) in the feed line (4) or respectively secondary feed line (22) for the cooling liquid is closed.

2. Method according to claim 1,
**characterised in that**
an operating pressure of between 20 and 900 mbar is generated in the low pressure range, with a temperature of the cooling liquid of from around 12 to 18°C.

3. Method according to claim 1 or 2,
**characterised in that**
water is used as cooling liquid.

4. Cooling arrangement for electrical and electronic components and module units, in particular high-performance servers, which are accommodated in device cabinets (2, 20) and similar,
with an installation for a cooling liquid circulating in the circuit which cooling arrangement has cooling devices (3) or respectively cabinet heat exchangers (21), a heat exchanger (6, 26) for cooling the cooling liquid with the aid of a refrigerant which can be outwardly discharged, at least one circulating pump (9) for circulating the cooling liquid and realising the cooling liquid circuit which is arranged upstream of the heat exchanger (6, 26), a feed line (4) and return line (5) or respectively a secondary feed line (22) and secondary return line (23) for the cooling liquid, wherein the cooling devices (3) are arranged on or in direct proximity to the electrical and electronic components and module units, and the cabinet heat exchangers (21) are respectively assigned to a device cabinet (20) for re-cooling of cooling air used to remove the heat loss of the electrical and electronic components and module units, and the feed line (4) extends from the heat exchanger (6) to the cooling devices (3) and the return line (5) extends from the cooling devices (3) to the heat exchanger (6), or respectively the secondary feed line (22) extends from the heat exchanger (26) to the cabinet heat exchangers (21) and the secondary return line (23) extends from the cabinet heat exchangers (21) to the heat exchanger (26),
with a low pressure device (10) which is arranged in the installation (3, 4, 5, 9; 21, 22, 23) for the cooling liquid to generate a low pressure lower than the atmospheric air pressure, wherein a low pressure range is formed in the installation (3, 4, 5, 9; 21, 22, 23) for the cooling liquid which extends from a throttle valve (11) in the feed line (4) via the cooling devices (3) as far as the low pressure device (10) in the return line (5) or respectively from the secondary feed line (22) via the cabinet heat exchangers (21) as far as the low pressure device (10) in the secondary return line (23), **characterised in that**
the low pressure device (10) has, besides the throttle valve (11) for adjusting the low pressure in the low pressure range, an air separator (12) and a low pressure pump (14) which is connected via a low pressure line (27) to the air separator (12) and keeps the operating pressure in the cooling liquid installation in the low pressure range below the atmospheric pressure,
a solenoid (15) is arranged upstream of the low pressure pump (14) on its low pressure side, and
a pressure switch (13) is arranged on the air separator (12) for controlling the solenoid (15), the low pressure pump (14) and a solenoid (16) in the feed line (4) or respectively secondary feed line (22), which pressure switch (13) is formed as a two-stage differential pressure switch and which, in the event of a pressure increase, switches on the low pressure pump (14) and opens the solenoid (15) arranged upstream thereof and, in the event of a further increase in the pressure above an alarm value, closes the solenoid (16) in the feed line (4) or respectively secondary feed line (22) for the cooling liquid.

5. Cooling arrangement according to claim 4,
**characterised in that**
cooling water is used as cooling liquid and cold water from the building water mains or a refrigerant is used as refrigerant, and the cold water or refrigerant is fed via a feed line (7) or respectively primary feed line (24) to the heat exchanger (6, 26) and removed via a return line (8) or respectively primary return line (25).

6. Cooling arrangement according to claim 4 or 5,
**characterised in that**
in the case of a cooling liquid circuit for supplying the cabinet heat exchangers (21) in device cabinets (20) of a cabinet arrangement, the low pr essure device (10), the heat exchanger (26) and redundant circulating pumps (9) are arranged in a unit (28) which forms an interface between the cold water mains of the building as a primary side and the cooling liquid supply of the cabinets or respectively racks as a secondary side.

7. Cooling arrangement according to claim 4,
**characterised in that**
in the case of a cabinet arrangement with a plurality of device cabinets (20) and respective air-liquid heat exchangers as cabinet heat exchangers (21) in each cabinet (20), a low pressure device (10) is arranged or respectively assigned to a cabinet (20).

## Revendications

1. Procédé pour refroidir des composants et des unités modulaires électriques et électroniques dans des armoires d'instruments (2, 20), en particulier dans des armoires de serveurs, selon lequel la chaleur dissipée par les composants et les unités modulaires électriques et électroniques est évacuée dans des dispositifs de refroidissement (3), au niveau de ou à proximité immédiate des composants et des unités modulaires électriques et électroniques, ou dans des échangeurs de chaleur d'armoire (21), qui sont associés à une armoire d'instruments (20) pour le recyclage de l'air de refroidissement utilisé pour l'évacuation de la chaleur dissipée par les composants et les unités modulaires électriques et électroniques, à l'aide d'un liquide de refroidissement circulant en circuit fermé, puis est transférée de ce liquide de refroidissement à un agent réfrigérant dans un échangeur de chaleur (6, 26) et évacuée par l'intermédiaire de celui-ci vers l'extérieur, le liquide de refroidissement circulant en circuit fermé à l'aide d'une pompe de circulation (9) qui est disposée en amont de l'échangeur de chaleur (6, 26) et, à l'aide d'un dispositif à dépression, une basse pression qui est plus faible que la pression de l'air atmosphérique est générée dans l'installation, pour le liquide de refroidissement, la basse pression étant générée seulement dans une zone de basse pression qui commence au niveau d'une vanne d'étranglement (11), dans une conduite d'amenée (4) de l'échangeur de chaleur (6) vers les dispositifs de refroidissement (3) ou, respectivement, dans une conduite d'écoulement secondaire (22) de l'échangeur de chaleur (26) vers les échangeurs de chaleur d'armoire (21) et, par l'intermédiaire des dispositifs de refroidissement (3) ou respectivement des échangeurs de chaleur d'armoire (21), arrive jusqu'au dispositif à dépression (10), dans une conduite de recyclage (5) correspondante ou, respectivement, une conduite de recyclage secondaire (23) pour le liquide de refroidissement,
**caractérisé :**
**en ce que** la basse pression est établie dans la zone de basse pression à l'aide d'une pompe à vide (14) qui est reliée par l'intermédiaire d'une conduite sous vide (27) à un séparateur d'air (12) et maintient la pression de fonctionnement dans l'installation du liquide de refroidissement, dans la zone de basse pression, au-dessous de la pression atmosphérique,
**en ce qu'**une vanne magnétique (15) placée en amont de la pompe à vide (14) du côté du vide est commandée par un interrupteur à pression (13) disposé au niveau du séparateur d'air (12) et qui est constitué sous la forme d'un interrupteur à pression différentielle à deux étages,
et **en ce que**, lors d'une augmentation de pression, la pompe à vide (14) est activée et la vanne magnétique (15) placée en amont par rapport à celle-ci est ouverte, et, lors d'une nouvelle augmentation de la pression au-dessus d'une valeur d'alarme, une vanne magnétique (16) se ferme pour le liquide de refroidissement dans la conduite d'amenée (4) ou, respectivement, dans la conduite d'écoulement secondaire (22).

2. Procédé selon la revendication 1,
**caractérisé :**
**en ce que**, dans la zone de basse pression, une pression de fonctionnement comprise entre 20 et 900 millibars est générée, avec une température du liquide de refroidissement située entre environ 12 et 18 °C.

3. Procédé selon la revendication 1 ou 2,
**caractérisé :**
**en ce que** de l'eau est utilisée comme liquide de refroidissement.

4. Système de refroidissement pour des composants et des unités modulaires électriques et électroniques, en particulier pour des serveurs à haute performance, qui sont logés dans des armoires d'instruments (2, 20) et similaires,
avec une installation pour un liquide de refroidissement circulant en circuit fermé, qui comprend des dispositifs de refroidissement (3) ou respectivement des échangeurs de chaleur d'armoire (21), un échangeur de chaleur (6, 26) pour le refroidissement du liquide de refroidissement à l'aide d'un agent réfrigérant pouvant être évacué vers l'extérieur, au moins une pompe de circulation (9) pour la circulation du liquide de refroidissement et la réalisation du passage en circuit fermé du liquide de refroidissement, qui est disposée en amont de l'échangeur de chaleur (6, 26), une conduite d'amenée (4) et une conduite de recyclage (5) ou respectivement une conduite d'écoulement secondaire (22) et une conduite de recyclage secondaire (23) pour le liquide de refroidissement, les dispositifs de refroidissement (3) étant disposés au niveau de ou à proximité immédiate des composants et des unités modulaires électriques et électroniques et les échangeurs de chaleur d'armoire (21) étant, chacun, associés à une armoire d'instruments (20) pour le refroidissement avec recyclage de l'air de refroidissement utilisé pour l'évacuation de la chaleur dissipée par les composants et les unités modulaires électriques et électroniques, et la conduite d'amenée (4) allant de l'échangeur de chaleur (6) vers les dispositifs de refroidissement (3) et la conduite de recyclage (5) des dispositifs de refroidissement (3) vers l'échangeur de chaleur (6) ou, respectivement, la conduite d'écoulement secondaire (22) de l'échangeur de chaleur (26) vers les échangeurs de chaleur d'armoire (21) et la conduite de recyclage secondaire (23) des échangeurs de chaleur d'armoire (21) vers l'échangeur de chaleur (26),
avec un dispositif à dépression (10), qui, dans l'installation (3, 4, 5, 9 ; 21, 22, 23) pour le liquide de refroidissement, est disposé pour la génération d'une basse pression plus faible que la pression de l'air atmosphérique, dans l'installation (3, 4, 5, 9 ; 21, 22, 23) pour le liquide de refroidissement, une zone de basse pression étant ainsi formée, qui va d'une vanne d'étranglement (11) dans la conduite d'amenée (4) en passant par les dispositifs de refroidissement (3) jusqu'au dispositif à dépression (10) dans la conduite de recyclage (5) ou respectivement de la conduite d'écoulement secondaire (22) par les échangeurs de chaleur d'armoire (21) jusqu'au dispositif à dépression (10) dans la conduite de recyclage secondaire (23),
**caractérisé :**
**en ce que** le dispositif à dépression (10) comprend, au voisinage de la vanne d'étranglement (11), pour le réglage de la basse pression dans la zone de basse pression, un séparateur d'air (12) et une pompe à vide (14) qui est reliée par l'intermédiaire d'une conduite sous vide (27) au séparateur d'air (12) et maintient la pression de fonctionnement dans l'installation du liquide de refroidissement, dans la zone de basse pression, au-dessous de la pression atmosphérique,
**en ce que** la pompe à vide (14) est précédée d'une vanne magnétique (15) située du côté du vide de celle-ci, et
**en ce qu'**il est prévu dans la conduite d'amenée (4) ou respectivement dans la conduite d'écoulement secondaire (22), au niveau du séparateur d'air (12), pour la commande de la vanne magnétique (15), de la pompe à vide (14) et d'une vanne magnétique (16), un interrupteur à pression (13) qui est constitué sous la forme d'un interrupteur à pression différentielle à deux étages et qui, lors d'une augmentation de pression, active la pompe à vide (14) et ouvre la vanne magnétique (15) qui est présente en amont par rapport à celle-ci, et, lors d'une nouvelle augmentation de la pression au-dessus d'une valeur d'alarme, ferme pour le liquide de refroidissement la vanne magnétique (16) dans la conduite d'amenée (4) ou respectivement dans la conduite d'écoulement secondaire (22).

5. Système de refroidissement selon la revendication 4,
**caractérisé :**
**en ce qu'**on utilise, comme liquide de refroidissement, de l'eau de refroidissement et, comme agent réfrigérant, de l'eau froide provenant du réseau d'eau du bâtiment ou un agent réfrigérant, et
**en ce que** l'eau froide ou l'agent réfrigérant est amené à l'échangeur de chaleur (6, 26) par l'intermédiaire d'une conduite d'écoulement et d'amenée (7) ou respectivement d'une conduite d'écoulement primaire (24) et est évacué par l'intermédiaire d'une conduite de recyclage (8) ou respectivement d'une conduite de recyclage primaire (25).

6. Système de refroidissement selon la revendication 4 ou 5,
**caractérisé :**
**en ce que**, pour un écoulement en circuit fermé du liquide de refroidissement, pour l'alimentation des échangeurs de chaleur d'armoire (21) dans des armoires d'instruments (2, 20) d'un agencement d'armoires, le dispositif à dépression (10), l'échangeur de chaleur (26) et des pompes de circulation (9) redondantes sont placés dans un dispositif (28) qui constitue une interface entre le réseau d'eau froide du bâtiment, comme côté primaire, et l'alimentation en liquide de refroidissement des armoires ou respectivement de racks, comme côté secondaire.

7. Système de refroidissement selon la revendication 4,
**caractérisé :**
**en ce que**, pour un agencement d'armoires comportant plusieurs armoires d'instruments (20) et, à chaque fois, un échangeur de chaleur air-liquide de refroidissement comme échangeur de chaleur d'armoire (21), un dispositif à dépression (10) est disposé dans chaque armoire (20), ou respectivement associé à une armoire (20).
